Europäisches Patentamt

European Patent Office

Office européen des brevets

(19)

(11) Veröffentlichungsnummer: **0 233 443**
**B1**

(12) # EUROPÄISCHE PATENTSCHRIFT

(45) Veröffentlichungstag der Patentschrift:
24.01.90

(51) Int. Cl.⁴: **G01R 19/22, H02H 3/33**

(21) Anmeldenummer: 86890037.4

(22) Anmeldetag: **19.02.86**

(54) Schaltungsanordnung zur Auswertung von von der Sekundärseite eines Übertragers gewonnenen Wechselstromsignalen.

(43) Veröffentlichungstag der Anmeldung:
26.08.87 Patentblatt 87/35

(45) Bekanntmachung des Hinweises auf die Patenterteilung:
24.01.90 Patentblatt 90/4

(84) Benannte Vertragsstaaten:
FR GB IT

(56) Entgegenhaltungen:
DE-A- 2 838 716
US-A- 4 307 305

IBM TECHNICAL DISCLOSURE BULLETIN, Band 26,
Nr. 8, Januar 1984, Seite 4091, New York, US; A.G.
BLACK et al.: "OP-AMP full-wave rectifier circuit"

(73) Patentinhaber: Schrack Elektronik-Aktiengesellschaft,
Pottendorferstrasse 25-27, A-1120 Wien(AT)

(72) Erfinder: Webley, Philip, Dipl.-Ing.,
Hardeggasse 67/8/2/8, A-1220 Wien(AT)
Erfinder: Listopad, Manfred, Klimschgasse 2/3/22,
A-1030 Wien(AT)

(74) Vertreter: Gibler, Ferdinand, Dipl.Ing.Dr.tech.,
Dorotheergasse 7/14, A-1010 Wien(AT)

## Beschreibung

Die Erfindung bezieht sich auf eine Schaltungsanordnung zur Auswertung von von der Sekundärseite eines Übertragers, dessen Primärseite auch von Störsignalen mit hoher Amplitude und kurzer Anstiegs- und Abfallzeit beaufschlagt ist, gewonnenen Wechselstromsignalen, bei der die Sekundärseite des Übertragers mit einer Verstärkeranordnung verbunden ist, die ausgangsseitig an eine Signalausworteschaltung, wie z.B. eine Schwellwertschaltung, angeschlossen ist.

Bei bekannten derartigen Schaltungen besteht die Verstärkeranordnung lediglich aus einem Verstärker. Damit ergibt sich der Nachteil, daß der Verstärker in beiden Richtungen aussteuerbar sein muß, wodurch eine entsprechend größere Betriebsspannung vorgesehen werden muß, die zu einem entsprechend hohen Leistungsbedarf führt.

Ein weiteres Problem bei den bekannten derartigen Schaltungen besteht darin, daß an der Primärseite des Wandlers auftretende Störimpulse mit hoher Amplitude und kurzen Anstiegs- und Abfallzeiten, wie sie z.B. durch Blitzschläge auf Freileitungen oder durch sehr schnelle Schaltvorgänge auftreten können, sekundärseitig zu einem Ansprechen der Signalausworteschaltung und somit zu einem Fehlverhalten der Schaltungsanordnung führen.

Ziel der Erfindung ist es, eine Schaltungsanordnung der eingangs erwähnten Art vorzuschlagen, bei der diese Nachteile vermieden sind.

Erfindungsgemäß wird dies dadurch erreicht, daß die Verstärkeranordnung zwei Verstärker aufweist, und die Sekundärseite des Übertragers mit jedem ihrer beiden Ausgänge mit je einem dieser Verstärker verbunden ist, und die Ausgänge der beiden Verstärker an denselben Eingang der Signalausworteschaltung angeschlossen sind, wobei der Ausgang eines jeden der beiden Verstärker über eine aus einer Diode und einem Widerstand gebildete Serienschaltung mit dem Eingang des jeweils anderen Verstärkers verbunden ist und an den Verbindungspunkt jeder dieser Dioden mit dem entsprechenden Widerstand jeweils eine Elektrode eines mit der anderen Elektrode an ein festes Potential geführten Kondensators angeschlossen ist.

Durch die Anordnung zweier Verstärker ist es möglich, jeden nur in einer Richtung auszusteuern wodurch es möglich ist, mit einer geringen Versorgungsspannung, verglichen mit der für die bekannten Schaltungen mit nur einem Verstärker, das Auslangen zu finden, wodurch sich auch ein entsprechend verminderter Leistungsbedarf ergibt. Weiters ergibt sich durch die Anordung der den Ausgang des einen Verstärkers mit dem Eingang des anderen Verstärkers verbindenden Serienschaltung der Diode und des Widerstandes in Verbindung mit dem Kondensator eine sehr einfache Sperrschaltung, welche die durch die auf der Primärseite des Wandlers auftretenden Störimpulse bedingt zufolge der Zeitkonstante des Übertragers in ihrem Verlauf einen Polaritätswechsel aufweisenden Störsignale an der Sekundärseite des Wandlers abblockt.

Hiebei soll die Zeitkonstante des aus Kondensator und Widerstand gebildeten Zeitgliedes größer als die Dauer der zu erwartenden, an der Sekundärseite des Übertragers auftretenden Störsignale sein.

In diesem Zusammenhang hat es sich als günstig erwiesen, wenn in Weiterbildung der Erfindung die Zeitkonstante des durch den Widerstand der Serienschaltung und den gegen ein festes Potential geführten Kondensator gebildeten Zeitgliedes wenigstens 1 ms beträgt.

Dadurch wird für eine durch Kapazität und Widerstandswert einstellbare Zeitdauer sicher eine Umkehr der Polarität am Eingang der Verstärker im Falle eines Störsignales vermieden, das in seinem Verlauf einen Polaritätswechsel aufweist und einen Signalanteil (positiv oder negativ) aufweist, der wesentlich langsamer gegen Null geht, als der andere und zwar so langsam, daß er innerhalb der Ansprechzeit der Schaltungsanordnung deren Ansprechschwelle erreicht, ohne daß aber durch diese weiterbildenden Merkmale der Erfindung eine wesentliche Verlängerung der Ansprechzeit der Schaltungsanordnung bedingt ist.

Bei einer Weiterbildung der Erfindung ist vorgesehen, daß die Ausgänge der beiden Verstärker über je eine Diode mit der Signalausworteschaltung verbunden sind. Damit wird sichergestellt, daß stets das Ausgangssignal mit der größeren Amplitude zu der Signalausworteschaltung durchgeschaltet wird.

Weiters kann vorgesehen sein, daß jeder Verstärker eine durch eine Parallelschaltung eines Widerstandes mit einer Diode gebildete Rückkopplung aufweist, wobei beide Dioden die gleiche Druchlaßrichtung aufweisen. Damit wird erreicht, daß nur positive Spannungen gegenüber dem Referenzpotential des Verstärkers an dessen Ausgang auftreten können, wodurch beide Verstärker im linearen Betrieb bleiben. Dabei können durch entsprechende Dimensionierung des Rückkopplungskreises die Verstärkereingänge sehr niederohmig ausgelegt werden.

Um die Verstärker über einen von mit stark unterschiedlichen Wechselspannungen gespeisten Gleichrichter versorgen zu können, kann nach einem weiteren Merkmal der Erfindung vorgesehen sein, daß die Versorgungsspannung ($U_{B-}$, $U_{B+}$) den beiden Verstärkern über einen PTC-Widerstand, zu dem vorzugsweise noch ein Ohm'scher Widerstand in Serie geschaltet ist, zugeführt ist wobei gegebenenfalls noch eine Spannungsbegrenzerschaltung, wie z.B. eine Zenerdiode, zu der Spannungsquelle ($U_{B-}$, $U_{B+}$) parallel geschaltet ist. Dadurch wird erreicht, daß die bei höheren Wechselspannungen über den PTC-Widerstand fließenden höheren Ströme zu einer entsprechenden Erwärmung dieses Widerstandes und damit zu einer Erhöhung seines Widerstandswertes führen, wodurch die Leistungsaufnahme der Schaltung entsprechend absinkt.

Aus der US-A 4 307 305 ist es bekannt, bei einem Präzisions-Vollwellen-Gleichrichter zwei Verstärker einzusetzen, die Dioden in ihren Rückkopplungszweigen aufweisen.

Die Erfindung wird nun an Hand der Zeichnung näher erläutert. Dabei zeigt:

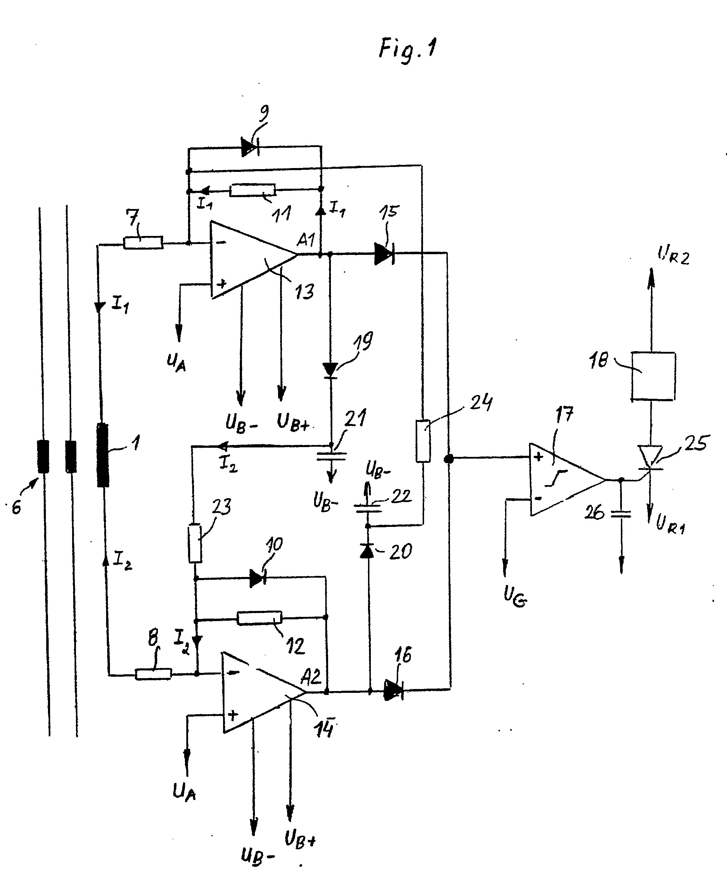

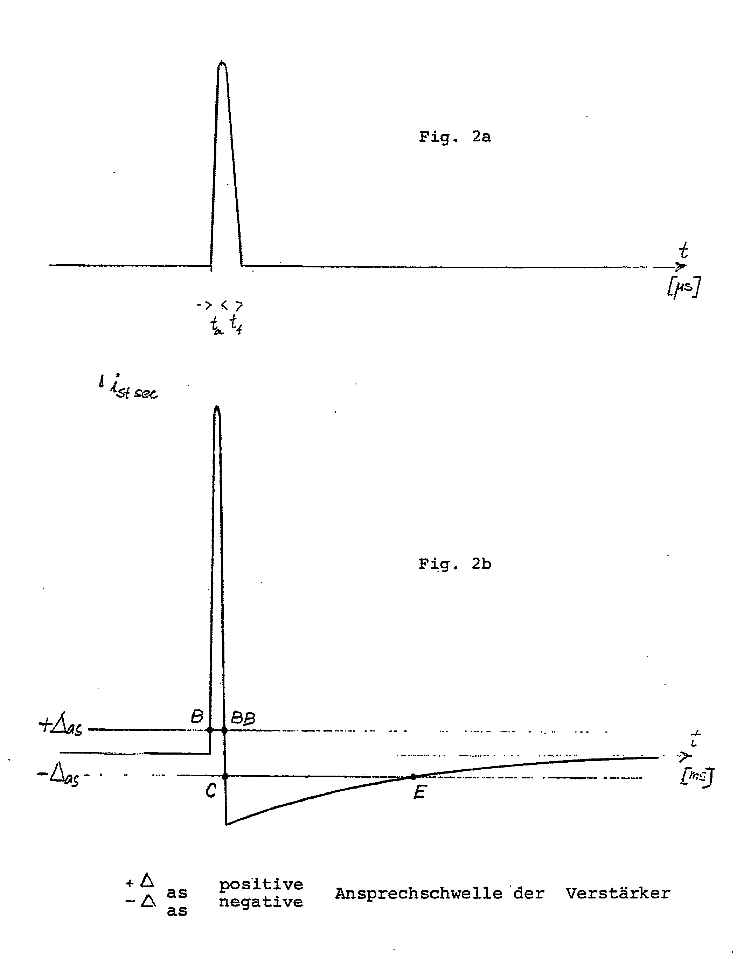

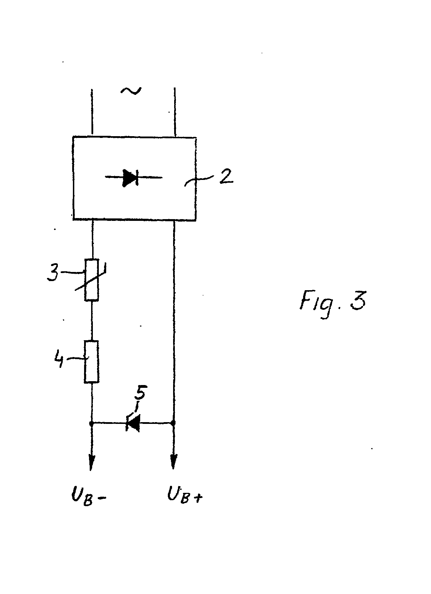

Fig. 1 eine Ausführungsform der erfindungsgemäßen Schaltungsanordnung, Fig.2 Diagramme eines möglichen primärseitigen Störimpulses und zugehörigen sekundärseitigen Störsignales und Fig.3 ein mögliches Schaltungsdetail zur Versorgung der Verstärker mit Betriebsspannung.

Bei der Schaltungsanordnung gemäß Fig. 1, die bei einem Fehlerstromschutzschalter eingesetzt werden kann, sind an den beiden Ausgängen der Sekundärwicklung 1 eines Summenstromwandlers 6 über die Widerstände 7, 8 je ein Verstärker 13 bzw. 14 angeschlossen. Beide Verstärker 13, 14 sind zweckmäßig mit der gleichen Versorgungsspannung $U_{B+}$ und $U_{B-}$ versorgt.

Diese Widerstände 7 und 8 können Teil einer Stoßspannungsschutzschaltung oder einer Funkentstörschaltung sein. Jeder dieser beiden. Verstärker ist als ein Operationsverstärker ausgebildet, wobei an den nichtinvertierenden Eingängen der Verstärker 13, 14 ein Potential $U_A$ angelegt ist. Weiters weist jeder Verstärker einen Rückkopplungskreis auf, der aus einer Parallelschaltung einer Diode 9 bzw. 10 zu einem Widerstand 11 bzw. 12 besteht. Dabei sind die beiden Dioden 9, 10 in den Rückkopplungskreisen in der gleichen Richtung durchlässig.

Die Ausgänge der beiden Verstärker 13, 14 sind über je eine Diode 15 bzw. 16 an einen Eingang einer Signalauswerteschaltung 17 gelegt, die vorliegendenfalls eine Schwellwertschaltung ist. Dadurch wird das jeweils größere Ausgangssignal der beiden Verstärker 13, 14 mit der an den zweiten Eingang der Schwellwertschaltung 17 angelegten Referenzspannung $U_G$ verglichen. Diese Schwellwertschaltung steuert einen Thyristor 25, der seinerseits einen Verbraucher 18 steuert, der von einer Spannung $U_{R1}$, $U_{R2}$ versorgbar ist. An den Ausgang der Schwellwertschaltung ist ferner ein gegen ein Bezugspotential geführter Kondensator 26 angeschlossen, welcher im wesentlichen die Ansprechzeit der Schaltungsanordnung festlegt.

Die von der Sekundärwicklung 1 kommenden Signale gelangen über die Widerstände 7, 8 zu den Eingängen der Verstärker, wobei aufgrund der Dioden 9, 10 in den Rückkopplungskreisen nur gegenüber dem Potential $U_A$ positive Spannungen an den Ausgängen der Verstärker 13, 14 auftreten können, wobei beide Verstärker im linearen Bereich bleiben. Da durch die Dioden 15, 16 eine direkte Verbindung der beiden Verstärkerausgänge unterbunden ist, gelangt stets das größere Ausgangssignal zu der Schwellwertschaltung 17, die bei einem über der Referenzspannung $U_G$ liegenden Eingangssignal den Thyristor 25 zündet.

Die Spannung $U_A$ kann nur wenig, z.B. 1,5 - 2 V, positiver als das Potential $U_{B-}$ der Versorgungsspannung der Verstärker 13, 14 gewählt werden. Weiters kann die Referenzspannung $U_G$ nur wenig negativer als das positive Potential $U_{B+}$ der Versorgungsspannung der Verstärker gewählt werden. Auf diese Weise wird die Betriebsspannung $U_{B-}$, $U_{B+}$ der Verstärker optimal genützt, wobei die Verstärker 13, 14 nur in jeweils einer Richtung aussteuerbar sein müssen.

An jedem der Ausgänge der beiden Verstärker 13, 14 ist eine aus einer Diode 19 bzw. 20 und einem Kondensator 21 bzw. 22 bestehende Serienschaltung angeschlossen, die eine Verbindung zu einem festen Potential herstellt. Weiters sind die Kondensatoren 21, 22 bzw. die Dioden 19, 20 über die Widerstände 23, 24 mit den invertierenden Eingängen der Verstärker 13 und 14 verbunden, wodurch sich eine Sperrschaltung für sekundärseitige Störsignale ergibt, die in ihrem Verlauf einen Polaritätswechsel aufweisen und einen Signalanteil (positiv oder negativ) haben, der wesentlich langsamer gegen Null geht als der andere und zwar so langsam, daß er innerhalb der Ansprechzeit der Schaltungsanordnung deren Ansprechschwelle erreicht. Solche sekundärseitigen Störsignale können z.B. durch kurze hohe Stromspitzen, wie sie z.B. bei Gewittern oder Schaltvorgängen im Netz auftreten, verursacht werden.

Gemäß den gültigen Vorschriften soll ein Fehlerstromschutzschalter bei Stromstößen von 500 A mit einer Anstiegszeit $t_a$ von 8 µs und einer Abfallzeit $t_f$ von 20µs nicht auslösen. Solche Stromstöße gemäß Fig. 2a führen aber dazu, daß an den Ausgängen der Sekundärwicklung des Übertragers 1 Ausgangssignale auftreten, wie sie Fig. 2 b mit vollen Linien zeigt.

Das sekundärseitige Störsignal gemäß Fig. 2b weist einen positiven und einen negativen Signalanteil und somit einen Polaritätswechsel in seinem Signalverlauf auf. Die im wesentlichen durch den Kondensator 26 bestimmte Ansprechzeit der Verstärkeranordnung liegt größenordnungsmäßig im ms-Bereich. Die Dauer des positiven Störsignalanteils ist nicht wesentlich anders als die Dauer des primärseitigen Störimpulses und liegt größenordnungsmäßig im µs-Bereich, z.B. 28 µs beim Normimpuls, so daß die Verstärkerschaltung auf diesen positiven sekundärseitigen Störsignalanteil sicher nicht ansprechen wird.

Da die Zeitkonstante

$$T = \frac{L}{R}$$

des Übertragers 1 aus den nachstehenden noch näher ausgeführten Gründen nicht beliebig groß gemacht werden kann, kommt es zu einem, den negativen Störsignalanteil verursachenden Ausschwingvorgang, der hinsichtlich seiner Dauer im ms-Bereich, also im Bereich der Ansprechzeit der Verstärkeranordnung, und hinsichtlich seiner Amplitude über der negativen Ansprechschwelle der Verstärker liegt, und somit ein Ansprechen der Verstärkeranordnung verursachen würde. Um dies zu verhindern, könnte die Zeitkonstante sehr groß gewählt werden, die Amplitude des Ausschwingvorganges würde dann die Ansprechschwelle nicht überschreiten. Dies ist aber aus folgenden Gründen nicht möglich. Insbesondere bei einer Anwendung für Fehlerstromschutzschalter muß diese Zeitkonstante webigstens einige Millisekunden betragen, damit der 50 Hz Fehlerstrom getreu übertragen wird. Unabhängig von diesem spezifischen Anwendungsfall sind aber der Forderung die Zeitkonstante möglichst groß zu wählen auch technologische Grenzen gesetzt, denn dies hieße, daß L sehr groß und R sehr klein gewählt werden muß, also Übertrager mit großem Eisenkern und Wicklungen großen Durchmesser verwendet werden müßten , was einerseits unwirtschaftlich und andererseits wegen des großen Platzbedarfes zumeist gar nicht möglich ist.Hier schafft die Anordnung der Bauteile 19, 21, 23 bzw. 20, 22, 24 Abhilfe wie folgt.

Gemäß Fig. 2b erreicht das durch einen z.B. positiven Stör - impuls gemäß Fig.2a sekundärseitig auftretende Störsignal ist sec zunächst in Punkt B die positive Ansprechschwelle +Δas, es fließt der Strom I₁.

Die Ausgangsspannung am Ausgang A1 des Verstärkers 13 wird ansteigen, weil der Operationsverstärker durchschaltet, und der Kondensator 21 wird sich praktisch auf UB+ vermindert um die Diodenspannung 19 aufladen. Zufolge der viel größeren Ansprechzeit der Verstärkeranordnung wird diese nicht ansprechen. Unterschreitet der Störimpuls die Ansprechschwelle +Δas beim Punkt BB, so fällt das Potential am Ausgang A1 des Operationsverstärkers 13 praktisch auf Null, der Kondensator 21 hält aber seine Spannung zufolge der Sperrwirkung der Diode 19. Diese Verhältnisse bleiben im wesentlichen erhalten, bis der nunmehr negative Störsignalanteil den Punkt C, also die negative Ansprechstelle -Δas, überschreitet. Der dann in der Schaltungsanordnung fließende Strom I₂ fließt in der zum Strom I₁ entgegengesetzten Richtung und zwar deshalb, weil der Eingang des Verstärkers 14 zufolge des aufgeladenen Kondensators 21 auf positivem Potential gehalten wird und dieser Verstärker 14 solange nicht öffnet, bis der Kondensator 21 entladen ist. Das heißt also, daß das vom sekundärseitigen Störsignal gelieferte negative Potential den Verstärker 14 nicht zu öffnen imstande ist und zwar so lange nicht, als bis der Kondensator 21 entladen ist. Die Entladezeit des Kondensators wird so gewählt, daß sie insgesamt länger dauert als das Abklingen des negativen Störimpulssignales bis unter die Ansprechschwelle (Punkt E), wodurch der Einfluß des negativen Anteiles des sekundärseitigen Störimpulssignales ausgeschaltet werden kann. Im allgemeinen wird diese Bedingung erfüllt sein, wenn die Zeitkonstante des RC-Gliedes 23, 21 bzw. 24, 22 wenigstens 1 ms beträgt. Vorstehend wurden die Verhältnisse für einen positiven, primären Störimpuls dargelegt, da das Schutzverhalten jedoch auf positive Störimpulse nicht beschränkt sondern ebenso auch für negative primäre Störimpulse, die einen positiven langandauernden Ausschwingsignalanteil aufweisen, Gültigkeit haben soll, ist die Schaltung symmetrisch aufgebaut; die Unterdrückung des positiven Signalausschwingvorganges gewährleistet dann das Entladen des Kondensators 22. Im Falle der Anwendung dieser Schaltung auf Fehlerstromschutzschalter muß die Zeitkonstante der RC-Glieder 21, 23 bzw. 22, 24 so gewählt werden, daß sie wesentlich kleiner als die Periode der Netzfrequenz ist und somit nur auf sehr schnelle Signaländerungen, wie sie bei Vorliegen von Störimpulsen auftreten, ansprechen. Bei langsamen Änderungen, wie sie im Zusammenhang mit dem bei 50 Hz auftretenden Fehlerströmen auftreten, können sich die Kondensatoren 21 bzw. 22 dann noch innerhalb der Abfallzeit des Fehlerstromsignales völlig entladen, sodaß es zu einem sicheren Ansprechen der erfindungsgemäßen Schaltungsanordnung kommt.

Für die Spannungsversorgung der Verstärker 13, 14 ist zweckmäßigerweise eine Schaltung gemäß Fig.3 vorgesehen. Bei dieser ist an einem Gleichrichter 2 eine aus einem PTC-Widerstand 3 und einem Widerstand 4 bestehende Reihenschaltung angeschlossen, wodurch in Verbindung mit einer Spannungsbegrenzerschaltung, vorliegendenfalls einer Zenerdiode 5, die Verstärker 13, 14 über ein Wechselspannungsnetz mit stark unterschiedlicher Spannung versorgt werden können. Dabei ändert sich bei steigender Wechselspannung aufgrund des dadurch bedingten erhöhten Stromflusses über die Zenerdiode 5 der Widerstandswert des PTC-Widerstandes, wegen der dadurch bedingten Erwärmung, wodurch der Stromfluß begrenzt wird und gleichzeitig die Leistungsaufnahme der Widerstände vermindert wird.

## Patentansprüche

1. Schaltungsanordnung zur Auswertung von von der Sekundärseite (1) eines Übertragers (6), dessen Primärseite auch von Störsignalen mit hoher Amplitude und kurzer Anstiegs- und Abfallzeit beaufschlagt ist, gewonnenen Wechselstromsignalen, bei der die Sekundärseite (1) des Übertragers (6) mit einer Verstärkeranordnung verbunden ist, die ausgangsseitig an eine Signalausverteschaltung (17), wie z.B. eine Schwellwertschaltung, angeschlossen ist,
dadurch gekennzeichnet,
daß die Verstärkeranordnung zwei Verstärker (13, 14) aufweist, und die Sekundärseite (1) des Übertragers (6) mit jedem ihrer beiden Ausgänge mit je einem dieser Verstärker (13, 14) verbunden ist, und die Ausgänge der beiden Verstärker (13, 14) an denselben Eingang der Signalausverteschaltung (17) angeschlossen sind, wobei der Ausgang (A1, A2) eines jeden der beiden Verstärker (13, 14) über eine aus einer Diode (19, 20) und einem Widerstand (23, 24) gebildete Serienschaltung mit dem Eingang des jeweils anderen Verstärkers (13, 14) verbunden ist und an den Verbindungspunkt jeder dieser Dioden (19, 20) mit dem entsprechenden Widerstand (23, 24) jeweils eine Elektrode eines mit der anderen Elektrode an ein festes Potential (UB-) geführten Kondensators (21, 22) angeschlossen ist.

2. Schaltungsanordnung nach Anspruch 1, dadurch gekennzeichnet, daß beide Verstärker (13, 14) mit der gleichen Versorgungsspannung (UB-, UB+) versorgt sind.

3. Schaltungsanordnung nach Anspruch 1 oder 2, dadurch gekennzeichnet, daß jeder Verstärker (13, 14) eine durch eine Parallelschaltung eines Widerstandes (11, 12) mit einer Diode (9, 10) gebildete Rückkopplung aufweist, wobei beide Dioden die gleiche Durchlaßrichtung aufweisen.

4. Schaltungsanordnung nach Anspruch 1, 2 oder 3, dadurch gekennzeichnet, daß die Ausgänge der beiden Verstärker (13, 14) über je eine Diode (15, 16) mit der Signalauswerteschaltung (19) verbunden sind.

5. Schaltungsanordnung nach einem der Ansprüche 1 bis 4, dadurch gekennzeichnet, daß die Versorgungsspannung (U$_{B-}$, U$_{B+}$) den beiden Verstärkern über einen PTC-Widerstand (3), der mit einem ohm'schen Widerstand (4) in Serie geschaltet ist, zugeführt ist, wobei gegebenenfalls noch eine Spannungsbegrenzerschaltung, wie z.B. eine Zenerdiode (5), zu der Spannungsquelle (U$_{B-}$,U$_{B+}$) parallel geschaltet ist.

6. Schaltung nach einem der Ansprüche 1 bis 4 dadurch gekennzeichnet, daß die Zeitkonstante des durch den Widerstand (23, 24) der Serienschaltung und den gegen ein festes Potential geführten Kondensator (21, 22) gebildeten Zeitgliedes wenigstens 1 ms beträgt.

## Claims

1. Circuit arrangement for evaluating alternating current signals obtained from the secondary side (1) of a transformer (6), the primary side of which is also subjected to interference signals with high amplitude and short rise and fall times, in which the secondary side (1) of the transformer (6) is connected to an amplifier arrangement, which is connected on the output side to a signal evaluation circuit (17), such as for example a threshold value circuit, characterized in that the amplifier arrangement has two amplifiers (13, 14) and the secondary side (1) of the transformer (6) is connected by each of its two outputs to one of these amplifiers (13, 14), and the outputs of the two amplifiers (13, 14) are connected to the same input of the signal evaluation circuit (17), the output (A1, A2) of each of the two amplifiers (13, 14) being connected via a series circuit formed from a diode (19, 20) and a resistor (23, 24) to the input of the other amplifier (13, 14) and in each case an electrode of a capacitor (21, 22) connected by the other electrode to a fixed potential (U$_{B-}$), being connected to the connecting point between each of these diodes (19, 20) and the corresponding resistor (23, 24).

2. Circuit arrangement according to Claim 1, characterized in that both amplifiers (13, 14) are supplied with the same supply voltage (U$_{B-}$, U$_{B+}$).

3. Circuit arrangement according to Claim 1 or 2, characterized in that each amplifier (13, 14) has a feedback formed by a parallel connection of a resistor (11, 12) to a diode (9, 10), both diodes having the same conducting direction.

4. Circuit arrangement according to Claim 1, 2 or 3, characterized in that the outputs of the two amplifiers (13, 14) are each connected via a diode (15, 16) to the signal evaluation circuit (17).

5. Circuit arrangement according to one of Claims 1 to 4, characterized in that the supply voltage (U$_{B-}$, U$_{B+}$) is fed to the two amplifiers via a PTC resistor (3), which is connected in series to an ohmic resistor (4), another voltage limiter circuit, such as for example a Zener diode (5), being connected in parallel to the voltage source (U$_{B-}$, U$_{B+}$), if required.

6. Circuit according to one of Claims 1 to 4, characterized in that the time constant of the time element formed by the resistor (23, 24) of the series circuit and the capacitor (21, 22) connected to a fixed potential is at least 1 ms.

## Revendications

1. Agencement de circuit pour l'évaluation de signaux de courant alternatif obtenus au secondaire (1) d'un transformateur (6) dont le primaire est également soumis à des signaux parasites de grande amplitude et de courte durée de montée et de descente, le secondaire (1) du transformateur (6) étant relié à un agencement d'amplification, raccordé du côté de la sortie à un circuit d'évaluation de signal (17) tel que, par exemple, un circuit à seuil, caractérisé en ce que l'agencement d'amplification comporte deux amplificateurs (13, 14), le côté secondaire (1) du transformateur (6) étant relié par l'intermédiaire de chacune de ses deux sorties à chacun de ces amplificateurs (13, 14) et les sorties des deux amplificateurs (13, 14) étant reliées à la même entrée du circuit d'évaluation de signal (17), en ce que la sortie (A1, A2) de chacun des deux amplificateurs (13, 14) est reliée, via un circuit série constitué d'une diode (19, 20) et d'une résistance (23, 24), à l'entrée de l'autre desdits amplificateurs (13, 14) et est raccordée au point de liaison de chacune de ces diodes (19, 20) avec la résistance correspondante (23, 24) chaque fois à une électrode d'un condensateur (21, 22) branché sur un potentiel fixe (U$_{b-}$) par son autre électrode.

2. Agencement de circuit selon la revendication 1 caractérisé en ce que les deux amplificateurs (13, 14) sont alimentés par la même tension d'alimentation (U$_{B-}$, U$_{B+}$).

3. Agencement de circuit selon la revendication 1 ou 2, caractérisé en ce que chaque amplificateur (13, 14) comporte un circuit de réaction constitué d'une résistance (11, 12) et d'une diode (9, 10) montées en parallèle, les deux diodes étant orientées dans la même direction de conductibilité.

4. Agencement de circuit selon la revendication 1, 2 ou 3, caractérisé en ce que les sorties des deux amplificateurs (13, 14) sont reliées chacune aux circuits d'évaluation de signal (17) par l'intermédiaire d'une diode (15, 16).

5. Agencement de circuit selon l'une des revendications 1 à 4, caractérisé en ce que la tension d'alimentation (U$_{B-}$, U$_{B+}$) est transmise aux deux amplificateurs via une résistance PTC (à coefficient de température positif) (3) branchée en série avec une résistance ohmique (4), un circuit de limitation de tension tel que, par exemple, une diode Zener (5) étant, le cas échéant, branché en parallèle à la source de tension (U$_{B-}$, U$_{B+}$).

6. Circuits selon l'une des revendications 1 à 4, caractérisé en ce que la constante de temps de l'organe de temporisation constitué de la résistance (23, 24) du circuit en série et du condensateur (21, 22) branché sur un potentiel fixe, atteint au moins 1 ms (une milliseconde).

*Fig.1*

Fig. 2a

$t$
$[\mu s]$

$t_a$ $t_f$

$i_{st\,sec}$

Fig. 2b

$+\triangle_{as}$

$B$   $BB$

$t$
$[ms]$

$-\triangle_{as}$

$C$

$E$

$+\triangle$ as    positive
$-\triangle$ as    negative    Ansprechschwelle der  Verstärker

$\sim$

2

Fig. 3

3

4

5

$U_{B-}$      $U_{B+}$